Europäisches Patentamt

European Patent Office

Office européen des brevets

(11) Publication number: **0 048 746**
**B1**

# EUROPEAN PATENT SPECIFICATION

(45) Date of publication of patent specification: **10.07.85**

(21) Application number: **81901070.3**

(22) Date of filing: **26.03.81**

(86) International application number:
**PCT/US81/00385**

(87) International publication number:
**WO 81/02960 15.10.81 Gazette 81/24**

(51) Int. Cl.⁴: **H 04 M 11/04,** G 08 C 19/00, H 04 B 3/54

(54) **AUTOMATIC METER READING SYSTEM.**

(30) Priority: **31.03.80 US 135875**

(43) Date of publication of application:
**07.04.82 Bulletin 82/14**

(45) Publication of the grant of the patent:
**10.07.85 Bulletin 85/28**

(84) Designated Contracting States:
**CH DE FR GB LI**

(56) References cited:
**US-A-4 012 734**
**US-A-4 114 141**
**US-A-4 127 845**
**US-A-4 161 720**
**US-A-4 204 195**

(73) Proprietor: **GENERAL ELECTRIC COMPANY**
**1 River Road**
**Schenectady New York 12305 (US)**

(72) Inventor: **FARNSWORTH, Richard George**
**308 York Street**
**York, ME 03909 (US)**
Inventor: **ROBINSON, Paul Bradford**
**9 Fogg Drive**
**Durham, NH 03824 (US)**

(74) Representative: **Hughes, Brian Patrick et al**
**Graham Watt & Co. Riverhead**
**Sevenoaks, Kent TN13 2BN (GB)**

Courier Press, Leamington Spa, England.

## Description

### Technical field

The present invention relates to an improved control unit for an automatic meter reading system. The invention is especially useful in automatic remote meter reading systems for reading and transmitting utility meter readings from the users premises to a central location for recordation and billing. For instance, the invention is especially useful for reading and transmitting data from electric power meters, or gas meters, or water meters, which measure consumption of those commodities.

### Background art

The present invention represents an improvement upon the prior system disclosed in US—A—4 161 720 and GB—A—1,543,501, General Electric Company, published on 4 April 1979. In these prior systems, a reading control center communicates over voice grade communication lines with a number of section control units frequently referred to herein simply as "control units", and through the control units and through electric power lines to individual meter terminal units. The present invention relates particularly to improved control units for use in such systems. The control units of the prior systems were capable of rapidly receiving commands from the reading control center and transmitting corresponding commands to the meter terminal units, and for receiving messages in response to the commands, and for transmitting corresponding messages back to the reading control center.

However, in a large system, there are a tremendous number of different terminal units to which commands must be sent, and from which messages must be processed. Accordingly, it has been determined that it is very desirable to provide for additional speed and efficiency in the operation of the control units in relaying commands from the reading control center to the appropriate terminal units, and in relaying corresponding data messages from the terminal units back to the reading control center.

### Disclosure of invention

It is a major object of the present invention to provide an improved automatic meter reading system which provides for greatly improved speed and efficiency in the handling of commands and messages to be transmitted between the reading control center and the meter terminal units and which compensates for weak transmissions from the meter terminal units.

The present invention relates to an automatic meter reading system as disclosed in US—A—4 161 720 for reading the measurement of a commodity over a power line, the system including a plurality of control units, a plurality of addressable terminal units connected to the power line, each of said terminal units being substantially instantaneously responsive to commands received thereby which contain a recognizable address to transmit messages representative of measurement data onto the power line; a reading control center having a common channel for transmitting commands and receiving messages and being operable to transmit commands each having at least transmit and receive address fields which identify at least one of said control units and further having an action field identifying at least one terminal unit; each of said control units being connected to the common channel of said reading control center and to the power line for selectively transferring commands and messages between said reading control center and said terminal units, each of said control units including, data processing and communication means for receiving commands from said reading control unit and for communicating messages thereto, address means for providing transmit and receive address signals representative of transmit and receive addresses unique to a control unit, and means for selectively comparing the contents of the transmit and receive address fields in commands received by said communication means with the transmit and receive address signals provided by said address means, said means for selectively comparing being operable to generate a transmit enable signal when there is a matching of the transmit address field contents and transmit address signals and to generate a receive enable signal when there is a match between the receive address field contents and the receive address signals to thereby selectively enable one control unit to transmit the action field of the received command to said terminal units and to receive messages from those terminal units responding to the action field of the command and to transfer the received messages to said reading control center. The system is characterized in that said data processing and communicating means is operable substantially simultaneously to (a) operate first receiving means to receive a currently received command within a group of commands from the reading control center and (b) operate first transmitting means to transmit an earlier received command within the same group of commands to the meter terminal units when an earlier command has been received and (c) to operate second receiving means to receive messages from the terminal units responding to a single earlier transmitted command within the same group of commands when an earlier command has been transmitted and (d) operates second transmitting means to transmit to the reading control center the messages from the meter terminal units responding to the single earlier transmitted command, the system being further characterized in that only one of said plurality of control units is operable upon the recognition of a match between the transmit address field contents and transmit address signals to generate a transmit enable signal and to transmit commands to said terminal units, and another one of said plurality of control units is operable in response to a match between the receive address field contents and the receive address signals to generate a receive enable signal and then to receive the messages from said terminal units and to transmit those messages to said reading control center.

Brief description of drawings

Fig. 1 is a schematic block diagram of an entire system according to the present invention.

Fig. 2 is a schematic block diagram showing the major components and interconnections of the control unit used in the system of Fig. 1.

Figs. 3 and 4, taken together, form a more detailed schematic diagram of the control unit of Fig. 2.

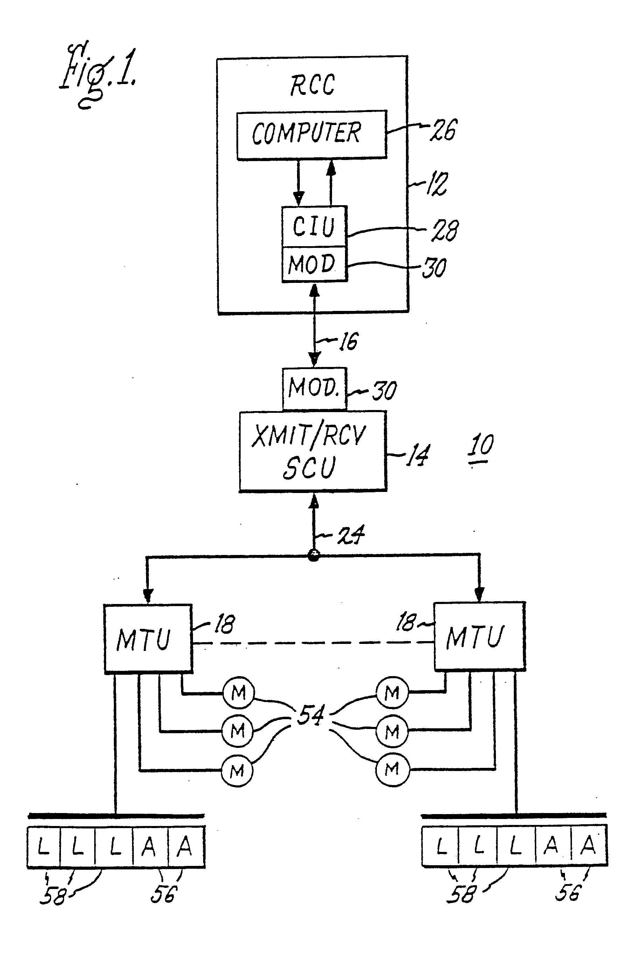

Best mode of carrying out the invention Referring particularly to Fig. 1 of the drawings, there is shown a schematic diagram of a system according to the present invention. The system is generally designated as 10 and includes a reading control center (RCC) 12 which communicates with a section control unit (SCU) 14 over a communication link 16. The section control unit 14 communicates with a plurality of meter terminal units (MTU) over a communication link 24. The communication link 24 preferably consists of an electric power distribution grid. Each meter terminal unit 18 has the capability of reading a plurality of different utility meters by taking readings from meter reading encoders 54. Each terminal unit 18 also has the capability of controlling a number of different loads 58 or alert signal devices 56. Each terminal unit also has the capability for reporting the status of a plurality of devices such as relay contacts (not shown). In the preferred embodiment, each meter terminal unit 18 has the capability for reading three meter encoders 54, controlling three external loads 58, and two alert signalling devices 56; and for reporting the status of up to six external contacts.

The reading control center 12 controls the overall operation of the system. Control center 12 includes a digital computer 26 which communicates with the rest of the system through one or more communications interface units (CIU) 28.

The communications interface unit 28 issues commands and receives data over the communication link 16, which is preferably a voice grade telephone circuit, through a modulator-demodulator circuit (MOD) 30. A similar modulator-demodulator circuit 30 is provided as shown at the section control unit 14 end of the communication link 16.

Preferably, the section control unit 14 is installed at a sub-station of the utility, such as the electric power utility which may be using the system. The section control unit then communicates with all of the meter terminal units 18 for customers who are served by that sub-station.

Commands or messages are transmitted from the section control units 14 over their associated power lines 24 preferably by means of carrier signals which are binary phase-modulated at thirty bits per second.

Generally, the meter terminal units 18 can be commanded to perform any of the following functions: reading and storing meter data, performing a reading of demand data and calculation of demand, transmitting previously stored meter or demand data, turning loads off and on, turning customer alerts on and off, and providing the status of external contacts.

The meter terminal units are individually addressable, group addressable, or block addressable. In each of the latter two cases, a number of meter terminal units are simultaneously addressed, and simultaneously respond to the commands.

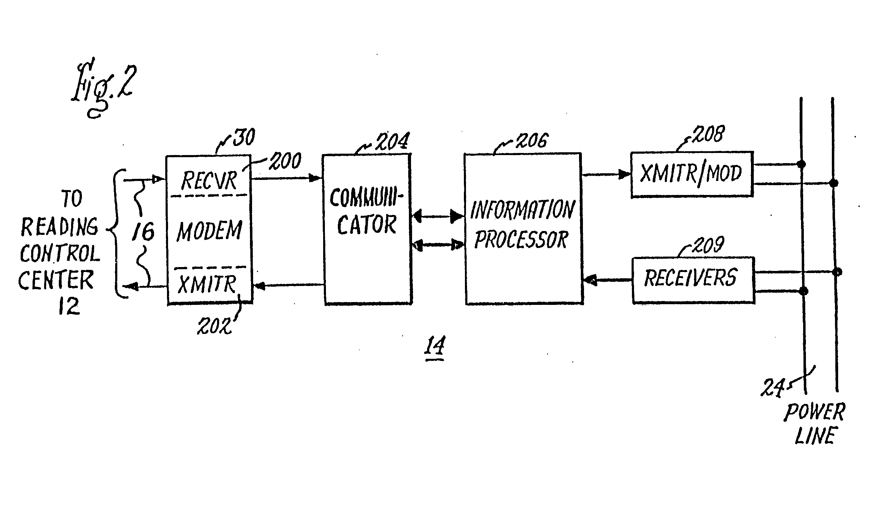

Referring more particularly to Fig. 2, there is shown a schematic block diagram of the section control unit 14 of Fig. 1. The control unit 14 includes a modulator-demodulator 30, which is commonly referred to as simply a "modem", and which includes a receiver 200 and a transmitter 202. The transmitter 202 of modem 30 transmits digital data signals on the telephone line 16 to the reading control center 12 on a carrier frequency. Typically, the transmitter 202 shifts back and forth between two carrier frequencies to indicate the presence of each digital "one" in a serial train of digital pulse signals. The receiver 200 of the modem 30 likewise receives signals on the telephone line 16 from the reading control center 12 which are also transmitted in the form of carrier signal pulses signified by shifting back and forth between two carrier signal frequencies. Alternatively, a single carrier may be switched on and off, or otherwise modulated, to carry the digital pulse signals received or transmitted. The carrier signal frequencies for the receiver are different from the carrier signal frequencies for the transmitter so that both sets of signals can exist on the telephone line at the same time, without interference. Since concurrent, or substantially simultaneous operation is available, the telephone line 16 is schematically indicated as comprising two lines in Fig. 2. As previously mentioned in connection with Fig. 1, a corresponding modem, including both a transmitter and a receiver, is provided at the reading control center 12.

The signals from the receiver 200 and to the transmitter 202 are handled within the control unit by means of a communicator circuit 204. The function of circuit 204 may be carried out by a synchronous receiver-transmitter circuit which is available as an integrated circuit component manufactured by Intel Corporation of Santa Clara, California, U.S.A., under product model No. 8251A. This component is sometimes referred to as a programmable communication interface. The communicator 204 receives commands from the reading control center 12 through receiver 200 which are in serial form, and converts those commands to a parallel format for transmission to an information processor 206, which is included within the control unit 14. The communicator 204 also receives messsage information from the information processor 206 in parallel form and converts that information to serial form for subsequent transmission through the transmitter 202 to the reading control center 12. The communicator 204 is preferably program controlled by the information processor 206.

The information processor 206 is operable in response to commands received from the reading control center 12 through receiver 200 and communicator 204 to transmit corresponding information or commands through a transmitter modulator 208 to the power line 24, and thus to the meter terminal units 18 of Fig. 1. The information processor 206 also responds to commands from the reading control center 12 to condition itself and to stand ready to receive information transmitted back from the meter terminal units 18 through the power line 24 and through receivers 209, whenever the original command orders the meter terminal units to transmit information.

The receiver 200 of Fig. 2 is sometimes referred to below as a first receiving means, and the receivers 209 are sometimes collectively referred to below as a second receiving means. The transmitter modulator 208 is sometimes referred to below as a first transmitting means and the transmitter 202 is referred to as a second transmitting means. Furthermore, the communicator 204 and the information processor 206 are sometimes collectively referred to below as a data processing and communicating means.

It is a very important feature of the present embodiment that the data communicator 204 and the information processor 206 are operable in combination to substantially simultaneously operate the receiver 200 to receive a currently received command within a group of commands from the reading control center 12, and to operate the transmitter 208 to transmit a command corresponding to an earlier received command within the same group of commands to the meter terminal units 18 (when an earlier command has been received), and to operate the receivers 209 to receive messages, from the terminal units 18 responding to a single earlier transmitted command within the same group of commands (when an earlier command has been transmitted), and to operate the transmitter 202 to transmit to the reading control center 12 messages from the meter terminal units 18 responding to the single earlier transmitted command.

In the above described substantially simultaneous transmissions and receptions of commands and messages, the control unit preferably operates such that when there is an earlier received command which is transmitted through the transmitter 208 to the terminal units, that earlier command is the earlier command received by the control unit immediately prior to the reception of the command which is currently received from the reading control center 12, and the messages received from the terminal units 18 are in response to the immediately preceding command transmitted to those terminal units.

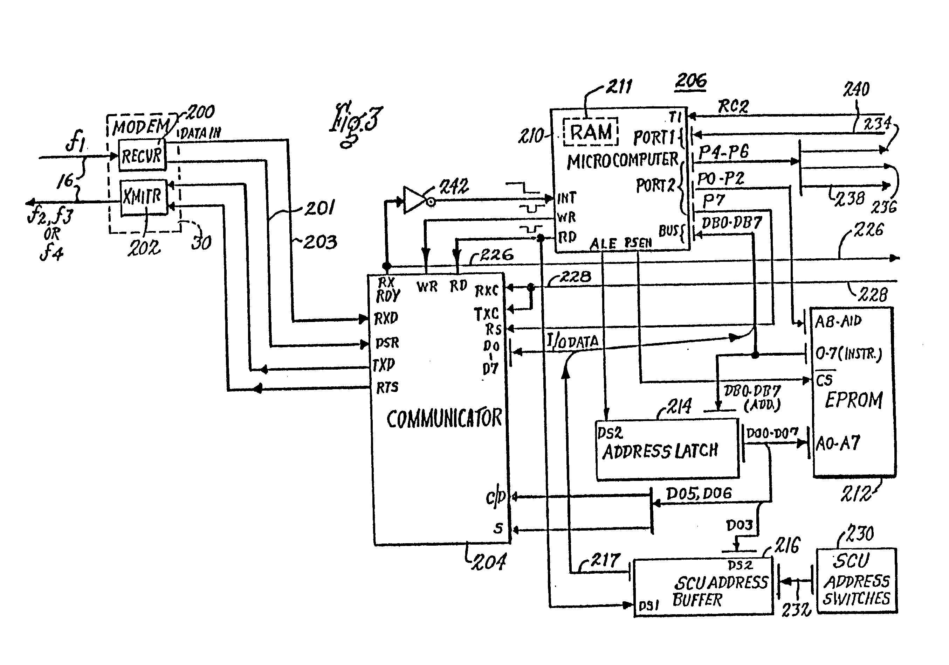

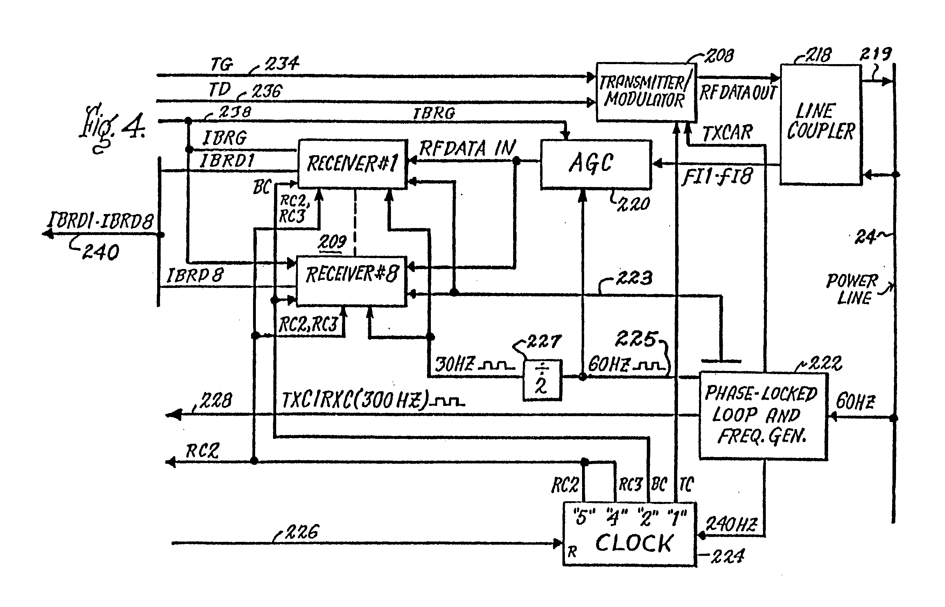

Figs 3 and 4, taken together, show the section control unit, generally referred to as the control unit 14, in a more detailed schematic block diagram. Fig. 4 should be placed to the right of Fig. 3 to best show how they relate to one another. Fig. 3 again shows the modem 30 with the receiver 200 and the transmitter 202 from Fig. 2, and the communicator 204 is again shown in Fig. 3. The transmitter modulator 208 of Fig. 2 is shown in Fig. 4, and the receivers 209 are shown to include preferably eight receivers 209 schematically indicated in Fig. 4.

Most of the details added to the schematic diagram of Figs. 3 and 4, in addition to showing additional connections, consist in the elaboration of the contents of the information processor 206. For information processor 206 preferably includes a microcomputer 210, which includes an internal random access memory "RAM" 211, an address latch circuit 214, an electrically programmable read only memory "EPROM" 212, an address buffer 216, and address switches 230, all of which are shown on Fig. 3. The information processor 206 also includes a clock generator 224 illustrated on Fig. 4.

Various components of the information processor may preferably be embodied by components available from Intel Corporation of Santa Clara, California, U.S.A., and carrying product model numbers as follows: the microcomputer 210 may be model 8035. The electrically programmable read only memory (EPROM) may be model 2716. The address latch circuit 214 and the address buffer 216 may each be model 8212. The microcomputer 210 is often referred to hereinafter as simply a computer.

The receiver 200 within the modem 30, in the preferred mode of operation, continuously receives a carrier signal having a frequency $f_1$ which is preferably a frequency of 660 Hz. The carrier signal frequency $f_1$ is continuously modulated in a predetermined pattern to provide a continuous stream of ASCII characters at a rate of 30 characters per second. ASCII is a standard pulse code representation for numbers and letters, the full identification of which is American National Standard Code for Information Interchange. Whenever the carrier is on, receiver 200 responds to the reception of the carrier to generate a "carrier detect in" signal which is carried on a connection 201 to a DSR input terminal of the communicator 204. Also, the modulated carrier is applied on a "data in" line 203 by the receiver to an RXD input terminal of the communicator 204. As each character is received, the communicator 204 generates a ready signal at an output terminal labelled RXRDY which is carried to an inverter circuit 242, and after inversion is carried to an INT input terminal of the computer 210. This signal as received by the computer, is interpreted as an interrupt signal which causes the initiation of the execution of a program by the microcomputer 210. The ready signal is also carried from the RXRDY output terminal on a connection 226 to the clock generator circuit 224 of Fig. 4, where it serves to synchronize the clock generator with the incoming signal received on the telephone line 16 from the reading control center 12. Since the clock generator 224 controls all of the clocking functions within the control unit, all of the operations of the control unit are thus synchronized with the signals from the reading control center 12. Thus, all of the clocking signals RC2, RC3, BC, and TC, are synchronized with the pulses from the reading control center. In order to assure continuous synchronization of the control unit with the reading control center 12, the carrier frequency $f_1$ is sent continuously by the reading control center and continuously modulated to provide a continuous train of binary 1's which are recognized by the system as "idle" characters which merely serve to synchronize the control unit with the reading control center.

When a command message is transmitted by the reading control center 12 and received by the control unit, ten characters will be stored by the communicator 204, and then transferred to the computer 210. As each of the ten characters is received, the ready signal received at the INT terminal of the computer 210 will cause an interrupt to the computer which commences the interrupt sub-routine program of the computer.

The random access memory (RAM) 211 within the computer 210 performs substantially all of the storage functions within the computer. RAM 211 is thus a working storage. RAM 211 includes a number of different addressable storage locations which are dedicated to the storage of different information. In particular, at least two of the data word positions within RAM 211 are devoted to the purpose of storing the first and second commands of a set of commands received from the reading control center 12. Additional addressable positions within the RAM 211 are devoted to a storage of counts, and are characterized as counters which are associated with the storage for the first and second commands, and which are responsive to the signals from clock 224 for counting the characters of the commands received by the control unit.

The interrupt program sub-routine is commenced by providing a specific bit configuration on the computer bus lines DB0—DB7. This bit configuration is applied to the address latch circuit 214. To latch the address into the address latch circuit 214, an enable signal is also supplied from the computer 210 output terminal ALE to the DS2 input terminal of the address latch circuit 214. The receipt of the address by the address latch circuit 214 results in the emission of signals on output lines DO5 and DO6 from the address latch circuit 214 to the C/D (control/data) and S (select) input terminals of the communicator 204. The communicator 204 is now conditioned to supply the character information to the computer 210 upon the emission of a read signal from the RD terminal of the computer 210 to the RD terminal of the communicator 204. The read signal is a pulse which will cause the character to be transferred from communicator 204 through communicator terminals D0—D7 into the computer bus port lines DB0 through DB7 (in parallel form). Thus, the characters are each received in the form of a serial train of pulses from the reading control center 12, are stored in communicator 204, and then the components are read out in parallel form from communicator 204 to computer 210. For each character received by the communicator 204, the above process will be repeated to transfer that character into the computer 210.

The communicator 204 is controlled from the computer 210 to transfer data from the computer to the reading control center 12 through the transmitter 202. This is accomplished by the computer 210 by executing a command which conditions the communicator 204 with a binary signal of sense opposite to the sense of the previous signal applied to the control data (C/D) input terminal of the communicator 204 through address latch 214. The computer can then transfer through the bus connections DB0 through DB7, a control word into the communicator 204 at terminals D0 through D7 upon the application of a write pulse from the WR terminal of the computer 210 to the WR terminal of communicator 204. The control word thus transferred to communicator 204 will condition the communicator to receive subsequent data words from computer 210 with the generation of each write pulse.

When communicator 204 is commanded to transfer information to the reading control center 12, the communicator will enable the modem transmitter 202 by applying a binary 1 output signal from the communication RTS terminal to the modem transmitter 202. The information is then shifted out from the communicator TXD output terminal, the timing of this operation being controlled by a 300 Hz timing signal received from the clock frequency generator 224 on connection 228 to terminals RXC and TXC of communicator 204.

The output carrier frequency from the modem transmitter 202 can be any one of three different frequencies $F_2$, $F_3$, or $F_4$. These frequencies represent separate sub-channel frequencies to allow more than one control unit to simultaneously communicate with a single communication channel of the reading control center 12. Usable frequencies for this purpose may be, for instance, $F_2$ equal to 1260 Hz, $F_3$ equal to 1860 Hz, and $F_4$ equal to 2460 Hz. As previously described, the binary pulse coded information may be transmitted by the modem transmitter 202 by shifting between two frequencies of the carrier, in which case, a complementary frequency is employed with each of the frequencies $F_2$, $F_3$, and $F_4$. However, if desired, the data can also be transmitted in binary pulse coded form by simply switching the carriers on and off, using only one frequency for each carrier.

The entire program for the computer is contained in the EPROM 212. The EPROM is addressed from the address latch 214 via its

output lines D00—D07 applied to the EPROM input terminals A0—A7. To select a particular address location in the EPROM during progam execution, an address is placed on the computer BUS DB0—DB7 and latched into the address latch 214 via the ALE output terminal applying the enable signal on terminal DS2 of the address latch. To now read the program component from the addressed location of the EPROM, the computer executes an instruction which causes its $\overline{PSEN}$ output terminal to provide a binary 0 select signal to a $\overline{CS}$ input terminal of the EPROM. This causes the addressed word in the EPROM 212 to be read out and transferred via the BUS DB0 through DB7 into the computer for execution of the retrieved instruction.

An output port 2 of computer 210 is connected through lines P0 through P2 to address input lines A8 through A10 of the EPROM 212 for page addressing of that memory as required by the system. The port 2 P7 output line from 210 is connected to a reset RS input terminal of the communicator 204. By the execution of an instruction by the microcomputer 210 the communicator 204 can be reset at a system start up in preparation to receiving and transmitting information between the control unit and the reading control center.

Whenever a command is received by the control unit from the reading control center 12, that command must be examined to see if it contains the address of the control unit which has received the command. The control unit accomplishes this testing by comparing its own address, which is predetermined by a plurality of address switches schematically indicated at 230. The settings of these switches provide input signals through associated lines 232 to the address buffer circuit 216.

In the course of accomplishing the test, the computer 210 executes an instruction to read the address buffer 216 into its internal memory 211. The computer does this by first selecting line D03 to enable terminal DS2 of the address buffer 216 through the address latch circuit 214. The computer 210 then generates a pulse on the RD output terminal to enable the DS1 input terminal of the address buffer 216 to cause the control unit address to be supplied at the connection 217 to the data bus connections DB0—DB7 of computer 210. This address is then compared by the computer with the received address contained in the command from the reading control center 12. If the compared addresses match, the computer will continue to carry out the operations specified by a function code portion of the command. Otherwise, the command is not carried out since it is not intended for this particular control unit.

Normally, when the command is to be carried out, it results in the transmission of a corresponding command through the transmitter 208 to the power line 24. To accomplish this, the computer 210 provides, through port 2, on one of the connections P4—P6 which is further identified as connection 234, a transmit gate signal (TG) to enable the transmitter/modulator 208. The computer 210 then proceeds to transmit the command in serial fashion through port 2 on the transmit data (TD) line 236 to transmitter 208. The TD signal on connection 236 modulates the transmitter carrier signal TXCAR which is applied to the transmitter/modulator from a phase locked loop and frequency generator circuit 222. The modulated output signal from the transmitter modulator 208 is coupled through a line coupler circuit 218 to the power line 24 at 219. The frequency of the carrier is preferably 5010 Hz. The data bit rate of transmission is controlled by a transmit clock signal TC at 30 Hz which is applied to the transmitter modulator 208 from the clock generator 224. When the entire command has been transmitted to the meter terminal units, the computer 210 turns off the transmit gate signal TG, thus disabling the transmitter modulator 208.

If the function code portion of the command received from the reading control center 12, as decoded by computer 210, indicates that there is an expectation of a response from one or more of the addressed terminal units, the computer will generate an "IBRG on" signal on line 238 from port 2. That signal is carried to all of the receivers 209, as well as to an automatic gain control circuit 220 in Fig. 4, to enable those components to receive messages returning from the meter terminal units. The meter terminal unit messages may come from as many as eight separate addressed meter terminal units simultaneously, at different carrier frequencies FI1 through FI8, and are simultaneously received through the line coupler 218 and the automatic gain control circuit 220 by all eight of the receivers 209. The individual receivers 209 are tuned to respond to the different individual carrier frequency signals by means of local oscillator signals from the phase locked loop and frequency generator circuit 222 over connections 223.

The clock circuit 222 also receives a 60 Hz signal from the power line 24 and provides a 60 Hz output signal at connection 225 which is applied to the automatic gain control circuit 220 for gain control purposes. The 60 Hz signal is also divided by 2 by means of a frequency divider 227 to provide a 30 Hz gating signal for gating the received binary digits from the receivers 209 which are applied through the data signal lines IBRD1—IBRD8 on conductors 240 back to port 1 of the computer 210. Additional 30 Hz timing signals RC2, RC3, and BC are provided from the system clock 224 to the receivers 209 for timing purposes.

As previously mentioned above, the system clock 224 is synchronized in its operation with the timing of the digital pulse signal train received from the reading control center 12 through the receiver 200, which is preferably at a uniform pulse rate of about 30 Hz. The transmitter modulator 208 of Fig. 4 is then caused to operate to transmit data to the meter terminal units at a synchronized 30 Hz pulse rate, which is in synchronism with the clock 224. The receivers 209 then operate also to receive serial pulse trains of binary signals at the same basic 30 Hz pulse rate, and when messages are relayed back to the reading control center 12 through the transmitter 202, those messages are also in the serial binary pulse format at the same 30 Hz pulse rate, and in synchronism with the timing signals from the clock 224. Thus, the same pulse rate is used in all of the transmitters and receivers of the control unit, and all are in synchronism.

The commands received from the reading control center 12 include separate address and function code field portions, and the data processor 206, as shown in detail in Fig. 3, embodies decode means responsive to the address and function field code portions of the commands to effect the transfer of the received commands to terminal units 18 corresponding to the address and function code fields recognized by the decode means whenever the contents of those fields identify at least one terminal unit. The command also enables the control unit to transfer messages back to the reading control center 12 from those terminal units 18 which recognize the function code and an address in the action field of commands received by the terminal units 18. The decode means is embodied in the computer 210 and the address buffer 216 and the address switches 230.

The counters, previously referred to above, which are associated with storage positions within RAM 211, are each responsive to clock signals for counting the characters of the commands received by the control unit, and the computer 210 includes a control means which is responsive to the counts in the counters to effect a generation of control signals at prescribed counts of the respective counters to selectively identify the respective storage positions for the first and second commands and to control the time of storage of the first and second commands in the selectively identified storage positions for those commands and to control the time of transmission of the first and second commands from those storage positions to the terminal units 18.

As previously mentioned above, the EPROM 212 of Fig. 3 stores a number of sub-routine programs for execution by the computer 210. One of these sub-routine programs is an interrupt sub-routine which is entered upon receipt of a command from the reading control center 12, when a resulting interrupt signal is caused to be applied to the computer 210 at the interrupt (INT) input terminal. The interrupt sub-routine directs entry to others of the sub-routine programs which cause the computer to carry out the various operations previously described, including the substantially simultaneous operation of the receivers 200 and 209 and of the transmitters 202 and 208.

The communicator 204 is very important to the operation of the control unit. Thus, the communicator 204 is operable to couple the computer 210 through the receivers 209 and the transmitter 202 for causing the reception of messages from the terminal units 18 and the storage of those messages in the RAM 211 of the computer 210, and for causing the transmission of those messages from the RAM 211 to the reading control center 12 through the transmitter 202. The communicator 204 and the computer 210 are also operable together to sequentially transfer commands received from the reading control center 12 through the receiver 200 into the RAM 211, and to provide the aforementioned interrupt signal to the computer at prescribed intervals as commands are received from the control center to thereby affect entry by the computer 210 into the interrupt sub-routine with each interrupt signal to thereby selectively direct entry into the other sub-routines for execution to carry out the substantially concurrent reception and transmission of commands and messages being transferred between the control center 12 and the terminal units 18.

It is one of the features of the control unit of the present embodiment that the computer 210 may be operable to append control unit status information to all of the messages from the meter terminal units 18 at the time those messages are transmitted from the control unit to the reading control center 12. Thus, the messages include status information of the control unit as well as information from the meter terminal units.

It is another feature of the embodiment that the computer 210 is operable in response to a special command from the reading control center 12 to respond with a message to the reading control center containing only control unit status information, and not including any meter terminal unit information, but having the same format as other messages transmitted to the reading control center 12.

It is another feature of the present embodiment that a plurality of the control units described in detail above may be incorporated in a single system in communication with a single reading control center 12. The system further typically includes a large number of meter terminal units 18, as shown in Fig. 1, which are in communication with various control units 14 through the power line 24. The terminal units 18 are addressable, and are substantially instantaneously responsive to commands which contain a recognizable address to transmit messages representative of measurement data onto the power line 24. The commands transmitted from the reading control center 12 include at least transmit and receive address fields which identify one of the control units, and further have an action field identifying at least one terminal unit. Each of the control units 14 is connected to a common channel of the reading control center 12, as well as to the power line 24 for selectively transferring commands and messages between the reading control center 12 and the meter terminal units 18.

Each of the control units, as explained above, includes address means such as the address switches 230 and the address buffer 216 for providing transmit and receive address signals representative of transmit and receive addresses unique to the control unit. Also, each control unit includes, within the computer 210, means for selectively comparing the contents of the transmit and receive address fields in the commands received through the communicator 204 with the transmit and receive address signals provided by the address buffer 216. The computer operates in response to this comparison to generate a transmit enable signal when there is a matching of the transmit address field contents and the transmit address signals, and to generate a receive enable signal when there is a match between the receive address field contents and the receive address signals. These enablement signals enable the control unit to transmit the action field of the received command to the terminal units 18 and to receive messages from those terminal units 18 responding to the action field of the command and to transfer the received messages to the reading control center 12.

In accordance with another feature of the embodiment, the transmissions from the meter terminal units are often rather weak signals. Accordingly, it has been found to be advantageous to provide control units which are distributed in position around the power distribution system so as to place every meter terminal unit 18 within a reasonable distance of a control unit which can receive limited power meter terminal unit data messages. However, since the control unit messages are not weak in power, it is not necessary to provide a number of distributed position control units for transmitting messages to the terminal units 18.

Accordingly, it is a feature of the invention to provide a plurality of control units, using only one of the control units to recognize a match between the transmit address field provided by the address buffer and the transmit address signals of the command to generate a transmit enable signal and to transmit commands to the terminal units 18, while another one or more of the plurality of control units is operable in response to a match between the receive address field and the receive address signals to generate a receive enable signal and then to receive the messages from the terminal units 18 and to transmit those messages to the reading control center 12.

The control units in such a system are preferably arranged in a set of control units which operate together to process the same command, and additional sets of the control units may be connected to the common channel of the reading control center 12 and to the power line 24.

It is another feature of the embodiment that the terminal units 18 may be arranged in a plurality of separate groups, with each group connected to a separate power line 24, with at least one control unit being connected to each of the separate power lines to serve a separate group of the terminal units 18, but all of the control units may be connected to the reading control center on a common channel. The control units are all operable to receive commands from the reading control center at one frequency on the common channel, but the separate control units are operable to respond to the commands by sending messages to the reading control center on the common channel at different frequencies so as to provide for simultaneous transmission of messages from the various control units to the reading control center. The reading control center 12 is operable to receive and recognize the messages transmitted at the different frequencies from the separate control units.

As previously explained above, it is a very important feature of the embodiment that the control unit 14 is operable to substantially simultaneously receive a command through the receiver 200, and transmit an earlier received command to the meter terminal units 18 through the transmitter 208, and to receive messages at receivers 209 from the terminal units 18 responding to an earlier transmitted command, and to transmit messages back to the reading control center 12 through the transmitter 202. These substantially simultaneous operations are sometimes characterized as "interlacing".

**Claims**

1. An automatic meter reading system for reading the measurement of a commodity over a power line, the system including a plurality of control units (14), a plurality of addressable terminal units (18) connected to the power line, each of said terminal units (18) being substantially instantaneously responsive to commands received thereby which contain a recognizable address to transmit messages representative of measurement data onto the power line; a reading control center (12) having a common channel for transmitting commands and receiving messages and being operable to transmit commands each having at least transmit and receive address fields which identify at least one of said control units (14) and further having an action field identifying at least one terminal unit; each of said control units (14) being connected to the common channel of said reading control center (12) and to the power line (24) for selectively transferring commands and messages between said reading control center (12) and said terminal units (18), each of said control units (14) including,

data processing and communication means (204, 206, Fig. 3) for receiving commands from said reading control unit (12) and for communicating messages thereto,

address means (230, 216) for providing transmit and receive address signals representative of transmit and receive addresses unique to a control unit, and

means (in 210) for selectively comparing the contents of the transmit and receive address fields in commands received by said data procesing and communication means (204, 206) with the transmit and receive address signals provided by said address means (230, 216), said means for selectively comparing being operable to generate a transmit enable signal when there is a matching of the transmit address field contents and transmit address signals and to generate a receive enable signal when there is a match between the receive address field contents and the receive address signals to thereby selectively enable one control unit to transmit the action field of the received command to said terminal units (18) and to receive messages from those terminal units (18) responding to the action field of the command and to transfer the received messages to said reading control center (12), the system being characterized in that said data processing and communicating means (204, 206) is operable substantially simultaneously to

a) operate first receiving means (200) to receive a currently received command within a group of commands from the reading control center (12) and

b) operate first transmitting means (208) to transmit an earlier received command within the same group of commands to the meter terminal units (18) when an earlier command has been received and

c) to operate second receiving means (209) to receive messages from the terminal units (18) responding to a single earlier transmitted command within the same group of commands when an earlier command has been transmitted and

d) operates second transmitting means (202) to transmit to the reading control center (12) the messages from the meter terminal units (18) responding to the single earlier transmitted command,
the system being further characterized in that only one of said plurality of control units (14) is operable upon the recognition of a match between the transmit address field contents and transmit address signals to generate a transmit enable signal and to transmit commands to said terminal units (18), and another one of said plurality of control units (14) is operable in response to a match between the receive address field contents and the receive address signals to generate a receive enable signal and then to receive the messages from said terminal units (18) and to transmit those messages to said reading control center (12).

2. A system as claimed in claim 1, characterized in that said plurality of control units (14) comprises a set, and the system further includes additional sets of said control units (14) connected to the common channel of said reading control center (12) and to the power line (24).

3. A system as claimed in claim 2, characterized in that one of said control units (14) in at least one of the sets of control units is utilized only for transmitting commands to said terminal units (18) and the remainder of the control units (14) in each set is utilized only for receiving and transmitting messages from the associated terminal units (18) to said reading control center (12).

**Patentansprüche**

1. Ein automatisches Meßgerätelesesystem zum Lesen der Messung eines Gutes über eine Netzleitung, wobei das System mehrere Steuereinheiten (14), mehrere mit der Netzleitung verbundene, adressierbare Datenstationseinheiten (18), die jeweils im wesentlichen gleichzeitig auf empfangene Befehle ansprechen, die eine erkennbare Adresse enthalten, um Meßdaten darstellende Nachrichten auf der Netzleitung zu senden, ein Lesesteuerzentrum (12) aufweist, das einen gemeinsamen Kanal zum Senden von Befehlen und Empfangen von Nachrichten aufweist und betätigbar ist zum Senden von Befehlen, die jeweils wenigstens Sende- und Empfangsadreßfelder, die wenigstens eine der Steuereinheiten (14) identifizieren, und ein Aktionsfeld aufweisen, das wenigstens eine Datenstationseinheit identifiziert, wobei jede Steuereinheit (14) mit dem gemeinsamen Kanal des Lesesteuerzentrums (12) und der Netzleitung (24) verbunden ist zum selektiven Übertragen von Befehlen und Nachrichten zwischen dem Lesesteuerzentrum (12) und den Datenstationseinheiten (18), wobei jede der Steuereinheiten (14) aufweist:

— Datenverarbeitungs- und Kommunikationsmittel (204, 206, Fig. 3) zum Empfangen von Befehlen von der Lesesteuereinheit (12) und zum Kommunizieren von Nachrichten mit dieser,
— Adreßmittel (230, 216) zum Liefern von Sende- und Empfangsadreßsignalen, die Sende- und Empfangsadressen darstellen, die eine Steuereinheit bestimmen, und
— Mittel (in 210) zum selektiven Vergleichen der Inhalte der Sende- und Empfangsadreßfelder in Befehlen, die von den Datenverarbeitungs- und Kommunikationsmitteln (204, 206) empfangen sind, mit den Sende- und Empfangsadreßsignalen, die von den Adreßmitteln (230, 216) empfangen sind, wobei die Mittel zum selektiven Vergleichen ein Sendefreigabesignal, wenn eine Anpassung der Sendeadreßfeldinhalte und der Sendeadreßsignale vorhanden ist, und ein Empfangsfreigabesignal generieren können, wenn eine Anpassung zwischen den Empfangsadreßfeldinhalten und den Empfangsadreßsignalen vorhanden ist, um dadurch selektiv eine Steuereinheit freizugeben, um das Aktionsfeld des empfangenen Befehls an die Datenstationseinheiten (18) zu senden und Nachrichten von diesen Datenstationseinheiten (18) zu empfangen, die auf das Aktionsfeld des Rotors ansprechen, und um die empfangenen Nachrichten zu dem Lesesteuerzentrum (12) zu übertragen, dadurch gekennzeichnet, daß die Datenverarbeitungs- und Kommunikationsmittel (204, 206) betätigbar sind, um im wesentlichen gleichzeitig

a) erste Empfangsmittel (200) zu betätigen, um einen gerade empfangenen Befehl innerhalb einer Gruppe von Befehlen von dem Lesesteuerzentrum (12) zum empfangen, und

b) erste Sendemittel (208) zu betätigen, um einen früher empfangenen Befehl innerhalb der gleichen Gruppe von Befehlen an die Datenstationseinheiten (18) zu senden, wenn ein früherer Befehl empfangen wurde, und

c) zweite Empfangsmittel (209) zu betätigen, um Nachrichten von den Datenstationseinheiten (18) zu empfangen, die auf einen einzigen, früher gesendeten Befehl innerhalb der gleichen Gruppe von Befehlen antworten, wenn ein früherer Befehl gesendet worden ist, und

d) zweite Sendemittel (202) zu betätigen, um an das Lesesteuerzentrum (12) die Nachrichten von den Datenstationseinheiten (18) zu senden, die auf den einzelnen, früher gesendeten Befehl antworten,

wobei das System ferner dadurch gekennzeichnet ist, daß nur eine der mehreren Steuereinheiten (14) betätigbar ist beim Erkennen einer Anpassung zwischen den Sendeadreßfeldinhalten und den Sendeadreßsignalen, um ein Sendefreigabesignal zu generieren und Befehle an die Datenstationseinheiten (18) zu senden, und eine andere der mehreren Steuereinheiten (14) bei einer Anpassung zwischen den Empfangsadreßfeldinhalten und den Empfangsadreßsignalen betätigbar ist, um ein Empfangsfreigabesignal zu generieren und dann die Nachrichten von den Datenstationseinheiten (18) zu empfangene und diese Nachrichten an das Lesesteuerzentrum (12) zu senden.

2. System nach Anspruch 1, dadurch gekennzeichnet, daß die mehreren Steuereinheiten (14) einen Satz bilden und das System ferner zusätzliche Sätze von Steuereinheiten (14) aufweist, die mit dem gemeinsamen Kanal des Lesesteuerzentrums (12) und mit der Netzleitung (24) verbunden sind.

3. System nach Anspruch 2, dadurch gekennzeichnet, daß eine der Steuereinheiten (14) in wenigstens einem der Sätze der Steuereinheiten nur zum Senden von Befehlen zu den Datenstationseinheiten (18) verwendet ist und der Rest der Steuereinheiten (14) in jedem Satz nur zum Empfangen und Senden von Nachrichten von den zugeordneten Datenstationseinheiten (18) zum Lesesteuerzentrum (12) verwendet ist.

## Revendications

1. Un système automatique de lecture de compteurs, destiné à lire par l'intermédiaire d'une ligne de distribution d'énergie la mesure de la consommation d'une ressource, le système comprenant un ensemble d'unités de commande (14), un ensemble de terminaux adressables (18) connectés à la ligne de distribution d'énergie, chaque terminal (18) réagissant de façon pratiquement instantanée à des ordres qu'il reçoit et qui contiennent une adresse reconnaissable, en émettant sur la ligne de distribution d'énergie des messages représentatifs de données de mesure;

un centre de commande de lecture (12) ayant un canal commun pour émettre des ordres et pour recevoir des messages, et pouvant fonctionner de façon à émettre des ordres ayant chacun au moins des zones d'adresse d'émission et de réception qui identifient l'une au moins des unités de commande (14), et ayant en outre une zone d'action qui identifie au moins un terminal; chacune des unités de commande (14) étant connectée au canal commun du centre de commande de lecture (12) et à la ligne de distribution d'énergie (24), pour transférer sélectivement des ordres et des messages entre le centre de commande de lecture (12) et les terminaux (18), chacune de ces unités de commande comprenant,

des moyens de traitement et de transmission de données (204, 206, figure 3) destinés à recevoir des ordres à partir de l'unité de commande de lecture (12) et à transmettre des messages vers celle-ci,

des moyens de génération d'adresse (230, 216) destinés à produire des signaux d'adress d'émission et de réception représentatifs d'adresse d'émission et de réception propres à une unité de commande, et

des moyens (210) destinés à comparer sélectivement le contenu des zones d'adress d'émission et de réception dans des ordres reçus par les moyens de traitement et de transmission de données (204, 206), avec les signaux d'adresse d'émission et de réception produits par les moyens de génération d'adresse (230, 216), ces moyens de comparaison sélective pouvant fonctionner de façon à générer un signal de validation d'émission lorsqu'il y a une correspondance entre le contenu des zones d'adresse d'émission et des signaux d'adresse d'émission, et à générer un signal de validation de réception lorsqu'il y a une correspondance entre le contenu des zones d'adresse de réception et les signaux d'adress de réception, pour valider ainsi sélectivement une unité de commande, pour émettre vers les terminaux (18) la zone d'action de l'ordre reçu, et pour recevoir des messages à partir des terminaux (18) qui répondent à la zone d'action de l'ordre, et pour transférer les messages reçus vers le centre de commande de lecture (12), le système étant caractérisé en ce que les moyens de traitement et de transmission de données (204, 206) sont capables d'effectuer de façon pratiquement simultanée les opérations suivantes:

a) actionner des premiers moyens de réception (200) pour recevoir un order reçu au moment considéré appartenant à un groupe d'ordres qui provient du centre de commande de lecture (12) et

b) actionner des premiers moyens d'émission (208) pour émettre un order reçu précédemment, dans le même groupe d'ordres, vers les terminaux de compteurs (18) lorsqu'un ordre précédent a été reçu, et

c) actionner des seconds moyens de réception (209) pour recevoir des messages provenant des terminaux (18) répondant à un ordre unique émis précédemment dans le même groupe d'ordres, lorsqu'un ordre précédent a été émis et

d) actionner des seconds moyens d'émission (202) pour émettre vers le centre de commande de lecture (12) les messages provenant des terminaux de compteurs (18) répondant à l'ordre unique émis précédemment,

le système étant en outre caractérisé en ce qu'une seule des unités de l'ensemble d'unités de commande (14) peut, à la reconnaissance d'une correspondance entre le contenu des zones d'adress d'émission et les signaux d'adresse d'émission, générer un signal de validation d'émission et émettre des ordres vers les terminaux (18), et une autre unité parmi l'ensemble d'unités de commande (14) peut, en réponse à une correspondance entre le contenu des zones d'adresse de réception et les signaux d'adresse de réception, générer un signal de validation de réception et ensuite recevoir les messages provenant des terminaux (18) et émettre ces messages ver le centre de commande de lecture (12).

2. Un système selon la revendication 1, caractérisé en ce que l'ensemble d'unités de commande (14) constitue un groupe, et le système comprend en outre des groupes supplémentaires d'unités de commande (14) qui sont connectés au canal commun du centre de commande de lecture (12) et à la ligne de distribution d'énergie (24).

3. Un système selon la revendication 2, caractérisé en ce que l'une des unités de commande (14) dans l'un au moins des groupes d'unités de commande n'est utilisée que pour émettre des ordres vers les terminaux (18), et les unités de commande (14) restantes dans chaque groupe sont utilisées uniquement pour recevoir des messages provenant des terminaux associés (18) et pour émettre des messages vers le centre de commande de lecture (12).

*Fig.1.*

Fig. 2

TO READING CONTROL CENTER 12

16

RECVR — 30
MODEM — 200
XMITR — 202

COMMUNI-CATOR — 204

INFORMATION PROCESSOR — 206

XMITR/MOD — 208

RECEIVERS — 209

14

24 — POWER LINE

0 048 746

2

Fig.3

Fig. 4.

0 048 746